# EUROPÄISCHE PATENTANMELDUNG

(11) **EP 2 672 094 A1**
(43) Veröffentlichungstag der Anmeldung: **11.12.2013**
(21) Anmeldenummer: 13163738.1
(22) Anmeldetag: 15.04.2013
(51) Int. Cl.: F02D 41/20, H01L 41/04

(54) **Verfahren und Vorrichtung zur Ansteuerung eines piezoelektrischen Aktors**

(30) Priorität: 08.06.2012 DE 102012209616
(71) Anmelder: ROBERT BOSCH GMBH, 70442 Stuttgart (DE)
(72) Erfinder: Vendulet, Joachim Dietmar, 67700 Niederkirchen (DE)

(57) **Zusammenfassung**

Eine Anordnung (1) umfasst einen piezoelektrischen Aktor (2) und eine Steuerung (3). Die Steuerung (3) dient zum Ansteuern des piezoelektrischen Aktors (2) mit einem Steuersignal. Die Steuerung (3) passt das Steuersignal hierbei in Abhängigkeit von zumindest einer erfassten Betriebstemperatur an. Ferner ist ein Verfahren zur Ansteuerung eines piezoelektrischen Aktors (2) mit einem Steuersignal angegeben, wobei das Steuersignal in Abhängigkeit von zumindest einer erfassten Betriebstemperatur angepasst wird.

## Beschreibung

### Stand der Technik

Die Erfindung betrifft eine Anordnung mit einem piezoelektrischen Aktor und einer Steuerung, die zum Ansteuern des piezoelektrischen Aktors dient, sowie ein Verfahren zur Ansteuerung eines piezoelektrischen Aktors. Speziell betrifft die Erfindung das Gebiet der Brennstoffeinspritzventile für Brennkraftmaschinen.

Aus der DE 103 26 259 A1 ist ein Injektor für Kraftstoff-Einspritzsysteme von Brennkraftmaschinen, insbesondere von direkteinspritzenden Dieselmotoren, mit einem in einem Injektorkörper angeordneten Piezoaktor bekannt. Der Piezoaktor ist über erste Federmittel einerseits mit dem Injektorkörper und andererseits mit einem hülsenartigen Übersetzerkolben in Anlage gehalten. Ferner ist ein eine Düsenaustrittsöffnung aufweisender Düsenkörper vorgesehen, in dem eine abgestufte Düsennadel axial verschieblich geführt ist. Ein Steuerraum steht über einen Leckagespalt mit einer unter Einspritzdruck stehenden Kraftstoffzuführung in Verbindung. Der vom Piezoaktor betätigte Übersetzerkolben ist räumlich unmittelbar der Düsennadel zugeordnet, wobei die Düsennadel mit einem rückwärtigen Bereich, der einen größeren Durchmesser aufweist als ein düsenaustrittsseitiger Bereich der Düsennadel, in den Innenraum des Übersetzerkolbens eingepasst ist. Der am unteren Ende des Übersetzerkolbens ausgebildete Steuerraum dient zum hydraulischen Längenausgleich und als hydraulische Übersetzung für die Dehnungsbewegung des Piezoaktors.

Der aus der DE 103 26 259 A1 bekannte Injektor ermöglicht über die hydraulische Übersetzung einen gewissen Längenausgleich für temperaturbedingte Längenänderungen von Komponenten des Brennstoffeinspritzventils. Diese hydraulische Übersetzung ist jedoch mit einem gewissen Aufwand verbunden. Insbesondere werden zusätzliche Bauteile benötigt und eine Gesamtlänge des Brennstoffeinspritzventils wird hierdurch vergrößert.

### Offenbarung der Erfindung

Die erfindungsgemäße Anordnung mit den Merkmalen des Anspruchs 1 und das erfindungsgemäße Verfahren mit den Merkmalen des Anspruchs 9 haben den Vorteil, dass der Aufwand für eine Temperaturkompensation reduziert ist. Speziell kann eine Temperaturkompensation auch ohne den Verbau von zusätzlichen Temperaturkompensationsbauteilen erzielt werden.

Durch die in den Unteransprüchen aufgeführten Maßnahmen sind vorteilhafte Weiterbildungen der im Anspruch 1 angegebenen Anordnung und des im Anspruch 9 angegebenen Verfahrens möglich.

Der piezoelektrische Aktor ist in vorteilhafter Weise als keramisches Vielschichtbauteil ausgestaltet. Solch ein keramisches Vielschichtbauteil hat in der Regel einen negativen Temperaturausdehnungskoeffizienten. Der piezoelektrische Aktor ist in vorteilhafter Weise in ein Gehäuse, das aus einem oder mehreren Gehäuseteilen bestehen kann, eingebaut. Zur Herstellung solch eines Gehäuses können in vorteilhafter Weise metallische Werkstoffe zum Einsatz kommen, die in der Regel positive Temperaturausdehnungskoeffizienten haben. Durch die Anpassung des Steuersignals für den piezoelektrischen Aktor kann in vorteilhafter Weise die Differenz zwischen dem negativen Temperaturausdehnungskoeffizienten des piezoelektrischen Aktors und dem positiven Temperaturausdehnungskoeffizienten des metallischen Werkstoffs des Gehäuses ausgeglichen werden. Hydraulische Bauelemente für einen Temperaturausgleich können hierdurch entfallen. Außerdem vergrößert sich der Auswahlbereich für mögliche Werkstoffe für das Gehäuse. Speziell können kostengünstige Werkstoffe zum Einsatz kommen, die einen vergleichsweise großen Temperaturausdehnungskoeffizienten aufweisen.

In vorteilhafter Weise ist ein Brennstoffeinspritzventil mit einer Düsennadel vorgesehen, wobei das Brennstoffeinspritzventil den piezoelektrischen Aktor umfasst und wobei der piezoelektrische Aktor zum Betätigen der Düsennadel dient. Bei dieser bevorzugten Ausgestaltung kann der piezoelektrische Aktor in vorteilhafter Weise zum direkten Betätigen der Düsennadel dienen. Eine hydraulische Übersetzungseinrichtung zur mittelbaren Betätigung der Düsennadel von dem piezoelektrischen Aktor entfällt bei dieser Ausgestaltung. Dies wirkt sich außerdem günstig auf die erzielbare Steifigkeit der Ansteuerung aus.

In vorteilhafter Weise ist zumindest ein Temperatursensor vorgesehen, der zum Erfassen der zumindest einen Betriebstemperatur dient. Hierbei ist es ferner vorteilhaft, dass der zumindest eine Temperatursensor zumindest mittelbar zumindest eine Betriebstemperatur zumindest eines Gehäuseteils des Brennstoffeinspritzventils und/oder eine Betriebstemperatur des piezoelektrischen Aktors erfasst. Beispielsweise kann an einem geeigneten Ort innerhalb des Gehäuses des Brennstoffeinspritzventils nur ein einziger Temperatursensor angeordnet sein, der zumindest näherungsweise eine gemeinsame Betriebstemperatur des Gehäuseteils des Gehäuses und des piezoelektrischen Aktors misst. Dadurch reduziert sich der Aufwand für die Temperaturmessung sowie für die Temperaturmesssignalübertragung und Temperaturmesssignalauswertung.

Zusätzlich oder alternativ kann die Steuerung zumindest eine Betriebstemperatur auf Grundlage von einer gemessenen, momentanen Kapazität des piezoelektrischen Aktors erfassen. Hierbei wird eine Abhängigkeit der Kapazität von der Temperatur ausgenutzt, um beispielsweise rechnerisch die Betriebstemperatur zu bestimmen. Dies ermöglicht eine indirekte Erfassung der Betriebstemperatur. Somit kann die Temperaturmessung gegebenenfalls auch ohne Temperatursensoren erfolgen.

Vorteilhaft ist es auch, dass die Steuerung das Steuersignal in Abhängigkeit von der zumindest einen Betriebstemperatur so anpasst, dass in einer Ruhelage des piezoelektrischen Aktors ein unabhängig von der zumindest einen Betriebstemperatur vorgegebenes Soll-Spiel des piezoelektrischen Aktors im Brennstoffeinspritzventil zumindest näherungsweise beibehalten ist. Das unabhängig von der zumindest einen Betriebstemperatur vorgegebenes Soll-Spiel wird dadurch unabhängig von der momentan herrschenden Betriebstemperatur beibehalten. Somit wird eine Nullpunktverschiebung in der Ruhelage durch elektrisches Ansteuern der piezoelektrischen Abhängigkeit von der gerade herrschenden Betriebstemperatur der Bauteile erzielt, um so ein eventuell vorhandenes Spiel im Konstruktionsaufbau auszugleichen.

Hierdurch wird gewissermaßen im Ruhezustand des piezoelektrischen Aktors bereits ein elektrisches Feld angelegt, um den Temperaturausgleich zu erzielen. Da durch das angelegte elektrische Feld im Ruhezustand des piezoelektrischen Aktors bereits ein Temperaturausgleich erzielt werden kann, kann auf Bauteile zum Ausgleich des Spiels verzichtet werden. Wrd beispielsweise ein negatives Feld an den piezoelektrischen Aktor angelegt, dann zieht sich der piezoelektrische Aktor in Längsrichtung zusammen. Dies kann zur Vergrößerung des Spiels im System genutzt werden. Beim Anlegen eines positiven Feldes dehnt sich der piezoelektrische Aktor hingegen in Längsrichtung aus, wodurch das Spiel verkleinert werden kann.

Das in der Ruhelage vorgegebene Soll-Spiel des piezoelektrischen Aktors im Gesamtsystem kann nun für eine bestimmte Temperatur mit dem notwendigen Spiel ausgelegt werden. Ändert sich die Temperatur hiervon ausgehend im Gesamtsystem, dann wird die Ruhelage durch Anlegen eines entsprechenden elektrischen Feldes, das heißt eines Korrekturfeldes, beziehungsweise einer entsprechenden Spannung, das heißt einer Korrekturspannung, korrigiert und das Soll-Spiel wird zumindest näherungsweise beibehalten. Die Korrekturspannung kann negativ, positiv oder auch Null sein.

Somit ist es vorteilhaft, dass die Steuerung in Abhängigkeit von der zumindest einen erfassten Betriebstemperatur eine Steuerspannung des Steuersignals durch Addition einer positiven, negativen oder verschwindenden Korrekturspannung zu der Steuerspannung anpasst und dass die Steuerung den piezoelektrischen Aktor mit einer Gesamtspannung ansteuert, die sich aus der Summe der Steuerspannung und der Korrekturspannung zusammen setzt. In vorteilhafter Weise ist die Korrekturspannung in Abhängigkeit von der zumindest einen erfassten Betriebstemperatur aus einem Bereich von etwa -40 V bis etwa 250 V gewählt. Der Zusammenhang zwischen der Korrekturspannung und der zumindest einen erfassten Betriebstemperatur kann durch eine Kennlinie, eine Tabelle, anhand einer hinterlegten Rechenvorschrift oder durch eine Kombination solcher Möglichkeiten bestimmt werden.

Wenn der piezoelektrische Aktor in dem Brennstoffeinspritzventil zum Einsatz kommt und durch eine elektrische Ansteuerung ein Einspritzvorgang freigegeben wird, dann verschiebt sich im Ergebnis das Ausgangspotential für die Ansteuerung. Die Signalform der Steuerspannung des Steuersignals kann somit beibehalten werden. Denn der Zeitraum für die Änderung der Korrekturspannung entsprechend einer Temperaturänderung ist deutlich größer als die Signallänge des Steuersignals für einen einzelnen Einspritzvorgang.

### Kurze Beschreibung der Zeichnungen

Bevorzugte Ausführungsbeispiele der Erfindung sind in der nachfolgenden Beschreibung anhand der beigefügten Zeichnungen näher erläutert. Es zeigt:
Fig. 1 eine Anordnung mit einem piezoelektrischen Aktor und einer Steuerung in einer auszugsweisen, schematischen Schnittdarstellung entsprechend einem Ausführungsbeispiel der Erfindung und
Fig. 2 ein Diagramm zur Erläuterung der Funktionsweise der in Fig. 1 dargestellten Anordnung und eines Verfahrens zur Ansteuerung des piezoelektrischen Aktors durch die Steuerung entsprechend dem Ausführungsbeispiel der Erfindung.

### Ausführungsformen der Erfindung

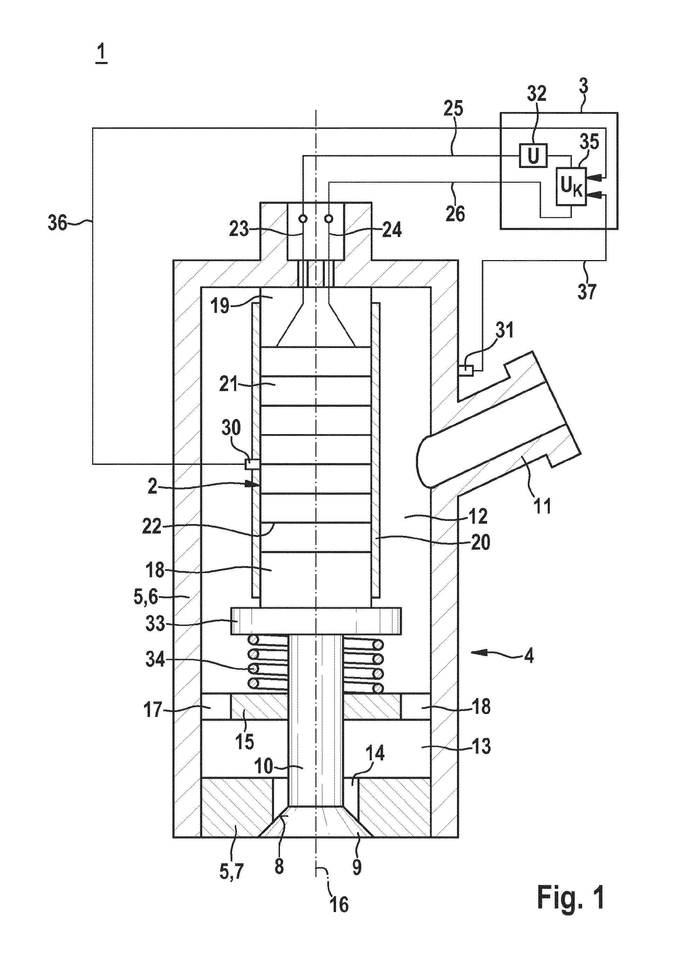

Fig. 1 zeigt eine Anordnung 1 mit einem piezoelektrischen Aktor 2 und einer Steuerung 3, die zum Ansteuern des piezoelektrischen Aktors 2 dient, in einer auszugsweisen, schematischen Schnittdarstellung entsprechend einem Ausführungsbeispiel. In diesem Ausführungsbeispiel umfasst die Anordnung 1 ein Brennstoffeinspritzventil 4, das den piezoelektrischen Aktor 2 aufweist. Das Brennstoffeinspritzventil 4 kann insbesondere als direkteinspritzendes Brennstoffeinspritzventil 4 ausgestaltet sein, das Brennstoff direkt in den Brennraum einer Brennkraftmaschine einspritzt. Die Anordnung 1 der Erfindung eignet sich allerdings auch für andere Anwendungsfälle.

Das Brennstoffeinspritzventil 4 weist ein Gehäuse 5 auf, das Gehäuseteile 6, 7 umfasst. Das Gehäuseteil 7 ist hierbei schematisch als Düsenkörper 7 dargestellt. An dem Düsenkörper 7 ist eine Ventilsitzfläche 8 ausgestaltet, die mit einem Ventilschließkörper 9 einer Düsennadel 10 zusammen wirkt.

An dem Gehäuse 5 ist ein Brennstoffeinlassstutzen 11 ausgestaltet, über den Brennstoff in das Gehäuse 5 geführt werden kann. In diesem Ausführungsbeispiel wird der Brennstoff in einen Aktorraum 12 im Inneren des Gehäuses geführt. Ferner ist ein Brennstoffraum 13 im Inneren des Gehäuses 5 vorgesehen, aus dem Brennstoff über einen Ringspalt 14 zwischen der Düsennadel 10 und dem Gehäuseteil 7 zu dem Dichtsitz zwischen dem Ventilschließkörper 9 und der Ventilsitzfläche 8 führbar ist.

Die Düsennadel 10 ist durch ein Gehäuseteil 15 entlang einer Längsachse 16 geführt. Über Brennstoffkanäle 17, 18 in dem Gehäuseteil 15 gelangt der Brennstoff aus dem Aktorraum 12 in den Brennstoffraum 13.

Der piezoelektrische Aktor 2 ist in dem Aktorraum 12 angeordnet. Der piezoelektrische Aktor 2 ist zwischen einem Aktorkopf 18 und einem Aktorfuß 19 angeordnet. Ferner ist der piezoelektrische Aktor 2 von einer Ummantelung 20 umgeben.

Der piezoelektrische Aktor 2 weist eine Vielzahl von keramischen Schichten 21 und eine Vielzahl von zwischen den keramischen Schichten 21 angeordneten Elektrodenschichten 22 auf. Zur Vereinfachung der Darstellung sind nur die keramische Schicht 21 und die Elektrodenschicht 22 gekennzeichnet. Die Elektrodenschichten 22 sind abwechselnd mit elektrischen Anschlüssen 23, 24 elektrisch verbunden. Die elektrischen Anschlüsse 23, 24 sind auf geeignete Weise aus dem Gehäuse 5 des Brennstoffeinspritzventils 4 herausgeführt. Die elektrischen Anschlüsse 23, 24 sind über geeignete elektrische Leitungen 25, 26 mit der Steuerung 3 verbunden.

Außerdem sind in diesem Ausführungsbeispiel Temperatursensoren 30, 31 vorgesehen. Der Temperatursensor 30 misst die Betriebstemperatur des piezoelektrischen Aktors 2. Der Temperatursensors 31 misst die Betriebstemperatur des Gehäuseteils 6 des Gehäuses 5. Die Darstellung und Anordnung der Temperatursensoren 30, 31 dient zur Veranschaulichung der Funktionsweise der Steuerung 3 sowie des von der Steuerung 3 durchgeführten Verfahrens. Vorzugsweise wird die zumindest eine Betriebstemperatur direkt oder indirekt erfasst und von der Steuerung 3 verarbeitet.

Die Steuerung 3 weist einen Steuersignal-Generator 32 auf. Der Steuersignalgenerator 32 erzeugt eine Spannung U. Der Spannungsverlauf der von dem Steuersignalgenerator 32 erzeugten Spannung U dient zur Erzeugung des zur Auslenkung des piezoelektrischen Aktors 2 entlang der Längsachse 16 erforderlichen Hubs für die Einspritzung von Brennstoff in die Brennkraftmaschine. In diesem Ausführungsbeispiel wird durch eine positive Steuerspannung U ein elektrisches Feld zwischen den Elektrodenschichten 22 erzeugt, so dass sich das keramische Material der keramischen Schichten 21 entlang der Längsachse 16 ausdehnt. Der sich in der Summe ergebende Hub des piezoelektrischen Aktors 2 überträgt sich über eine Druckplatte 33 direkt auf die Düsennadel 10. Somit betätigt der piezoelektrische Aktor 2 direkt die Düsennadel 10.

Die Druckplatte 33 ist mit der Düsennadel 10 verbunden. Wenn die Spannung U wieder verschwindet, das heißt gleich 0 V ist, dann ist der piezoelektrische Aktor 2 wieder auf seine Ausgangslänge verkürzt. Die Rückstellung der Düsennadel 10 in die Ausgangsstellung ist durch eine Ventilfeder 34 gewährleistet.

Somit wird entsprechend der Steuerspannung U des Steuersignal-Generators 32 ein Hub des Ventilschließkörpers 9 der Düsennadel 10 zum Öffnen und Schließen des Dichtsitzes zwischen dem Ventilschließkörper 9 und der Ventilsitzfläche 8 erzielt.

Das von der Steuerung 3 erzeugte Steuersignal beziehungsweise die Steuerspannung U des Steuersignals wird in Abhängigkeit der zumindest einen erfassten Betriebstemperatur angepasst. Hierfür weist die Steuerung 3 einen Korrekturspannungs-Generator 35 auf. Der Korrekturspannungs-Generator 35 erzeugt eine Korrekturspannung U_{K}. Die Korrekturspannung U_{K} wird hierbei in Abhängigkeit von der zumindest einen erfassten Betriebstemperatur vorzugsweise aus einem Bereich von etwa -40 V bis etwa 250 V erzeugt. Der momentane Wert der Korrekturspannung U_{K} ergibt sich hierbei aus dem momentanen Wert der zumindest einen erfassten Betriebstemperatur. Der numerische Zusammenhang kann beispielsweise durch eine oder mehrere Kennlinien, durch eine oder mehrere Tabellen, durch eine Rechenvorschrift oder durch eine Kombination solcher Maßnahmen bestimmt sein. Die Korrekturspannung U_{K} kann hierbei sowohl positive als auch negative Werte annehmen. Für zumindest einen Wert der zumindest einen Betriebstemperatur kann die Korrekturspannung auch verschwinden, das heißt gleich 0 V sein. Dies kann beispielsweise für einen Ausgangszustand von 20° C der Fall sein. Je nach Ausgestaltung kann die verschwindende Korrekturspannung allerdings auch für einen gewissen Beriebszustand vorgegeben sein, bei dem die Komponenten des Brennstoffeinspritzventils 4 bereits betriebsbedingt erwärmt sind.

Der Steuersignal-Generator 32 und der Korrekturspannungs-Generator 35 sind in Reihe geschaltet. Hierdurch addieren sich die Steuerspannung U des Steuersignals und die Korrekturspannung U_{K} zu einer Gesamtspannung U + U_{K}. Diese Gesamtspannung U + U_{K} wird zwischen die elektrischen Anschlüsse 23, 24 angelegt.

Wenn der Steuersignal-Generator 32 zwischen den Einspritzvorgängen eine verschwindende Steuerspannung U erzeugt, dann liegt zwischen den elektrischen Anschlüssen 23, 24 nur die Korrekturspannung U_{K} an, da sich die Gesamtspannung dann aus der Summe der Steuerspannung, die für diesen Zeitraum gleich Null ist, und der Korrekturspannung U_{K} ergibt.

In diesem Ausführungsbeispiel sind die Temperatursensoren 30, 31 über Messsignalleitungen 36, 37 mit dem Korrekturspannungs-Generator 35 verbunden. Durch eine geeignete Signaltrennung können die Messsignale der Temperatursensoren 30, 31 allerdings auch über die elektrischen Leitungen 25, 26 übertragen werden.

Zusätzlich oder alternativ kann die Steuerung 3 zumindest eine Betriebstemperatur auf Grundlage von einer gemessenen, momentanen Kapazität des piezoelektrischen Aktors 2 erfassen.

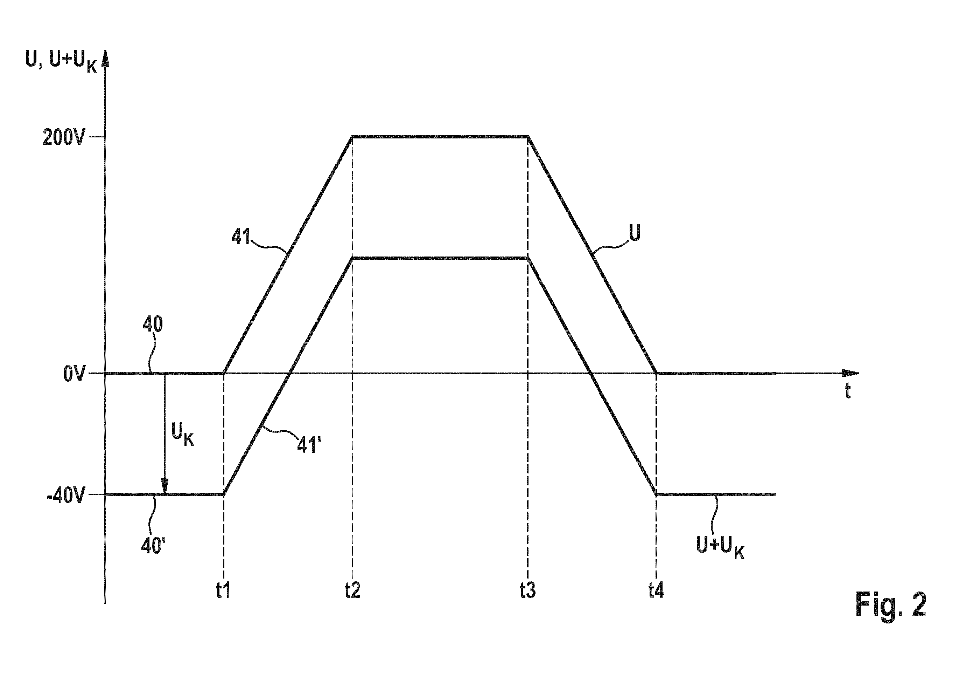

Fig. 2 zeigt ein Diagramm zur Veranschaulichung der Funktionsweise der Steuerung 3 der Anordnung 1 sowie des von der Steuerung 3 durchgeführten Verfahrens entsprechend dem Ausführungsbeispiel. Hierbei ist an der Abszisse die Zeit t angetragen. An der Ordinate sind die Steuerspannung U des Steuersignals des Steuersignal-Generators 32 und die Gesamtspannung U + U_{K} angetragen.

Die Steuerspannung U des Steuersignal-Generators 32 ist schematisch und idealisiert für eine Betätigung der Düsennadel 10 dargestellt. Auf einen Abschnitt verschwindender Steuerspannung U folgt eine ansteigende Flanke 41. Die ansteigende Flanke 41 beginnt zum Zeitpunkt t1 und endet zum Zeitpunkt t2. Dementsprechend wird eine Ausdehnung des piezoelektrischen Aktors 2 entlang der Längsachse 16 und somit einer Öffnungsbewegung der Düsennadel 10 bewirkt. Zum Zeitpunkt t2 bis zum Zeitpunkt t3 bleibt die Steuerspannung beispielsweise auf einem Wert von 200 V. Zum Zeitpunkt t3 bis zum Zeitpunkt t4 nimmt die Steuerspannung U wieder ab, wobei sie zum Zeitpunkt t4 0 V erreicht. Ab dem Zeitpunkt t4 ist die Steuerspannung U gleich 0 V. Hierdurch wird ein Einspritzvorgang mit einer singulären Einspritzung erzielt. Es sind allerdings auch andere Signalverläufe des Steuersignals mit der Steuerspannung U möglich. Insbesondere können auch Mehrfacheinspritzungen und/oder Teileinspritzungen bewirkt werden.

In der Fig. 2 ist ein Fall veranschaulicht, bei dem auf Grund der zumindest einen Betriebstemperatur eine negative Korrekturspannung U_{K} von dem Korrekturspannungs-Generator 35 erzeugt wird. Diese negative Korrekturspannung U_{K} beträgt beispielsweise - 40 V. Die Gesamtspannung U + U_{K}, die sich aus der Steuerspannung U und der Korrekturspannung U_{K} zusammen setzt, ist somit um -40 V gegenüber der reinen Steuerspannung des Steuersignal-Generators 32 nach unten verschoben. Hierdurch erfolgt eine Anpassung des Steuersignals. Der Abschnitt 40' der Gesamtspannung U + U_{K} liegt somit auf einem Niveau von -40 V. Bei verschwindender Steuerspannung U bewirkt dies für sich eine Verkürzung des piezoelektrischen Aktors 2 entlang der Längsachse 16. Andererseits kommt es auf Grund der zumindest einen Betriebstemperatur zu einer Differenz zwischen der Längenänderung des Gehäuseteils 6 entlang der Längsachse 16 und des piezoelektrischen Aktors 2 entlang der Längsachse 16, was sich im Ergebnis in einem gewissen Öffnungshub des Ventilschließkörpers 9 relativ zu der Ventilsitzfläche 8 auswirkt. Die Korrekturspannung U_{K} ist gerade so bestimmt, dass sich diese beiden Effekte ausgleichen. Somit wird auf Grund der Korrekturspannung U_{K} eine Temperaturkompensation erzielt. Speziell ist somit das Brennstoffeinspritzventil 4 während des Abschnitts 40' gerade geschlossen.

Während der ansteigenden Flanke 41' der Gesamtspannung U + U_{K} ergibt sich somit eine Öffnungsbewegung der Düsennadel 10, wie sie auf Grund des Steuersignals mit der Steuerspannung U erwartet wird. Der Signalverlauf des Steuersignals U zwischen dem Zeitpunkt t1 und dem Zeitpunkt t4 überträgt sich somit gerade in die gewünschte

Öffnungsbewegung der Düsennadel 10. In diesem Beispiel wird somit gerade ein zu frühes Öffnen und/oder ein zu weites Öffnen des Dichtsitzes zwischen dem Ventilschließkörper 9 und der Ventilsitzfläche 8 verhindert.

In entsprechender Weise erfolgt eine Temperaturkompensation mit einer positiven Korrekturspannung U_{K}. Hierbei wird speziell ein zu geringes Öffnen des Dichtsitzes zwischen dem Ventilschließkörper 9 und der Ventilsitzfläche 8 verhindert.

Speziell kann die Steuerung 3 das Steuersignal in Abhängigkeit von der zumindest einen Betriebstemperatur so anpassen, dass in einer Ruhelage des piezoelektrischen Aktors 2, insbesondere bis zum Zeitpunkt t1, ein unabhängig von der zumindest einen Betriebstemperatur vorgegebenes Soll-Spiel des piezoelektrischen Aktors 2, das ein zuverlässiges Schließen des Dichtsitzes zwischen dem Ventilschließkörper 9 der Düsennadel 10 und der Ventilsitzfläche 8 gewährleistet, in dem Brennstoffeinspritzventil zumindest näherungsweise beibehalten ist. Unabhängig von der jeweiligen zumindest einen Betriebstemperatur ist somit stets das gleiche Soll-Spiel des piezoelektrischen Aktors 2 während der Ruhelage gewährleistet. Das Einspritzverhalten, das durch die Steuerspannung U des Steuersignal-Generators 32 bestimmt wird, ist dadurch unabhängig von der Betriebstemperatur.

Die Erfindung ist nicht auf die beschriebenen Ausführungsbeispiele beschränkt.

## Patentansprüche

1. Anordnung (1) mit einem piezoelektrischen Aktor (2) und einer Steuerung (3), die zum Ansteuern des piezoelektrischen Aktors (2) mit einem Steuersignal dient, wobei die Steuerung (3) ausgestaltet ist, das Steuersignal in Abhängigkeit von zumindest einer erfassten Betriebstemperatur anzupassen.

2. Anordnung nach Anspruch 1,
**dadurch gekennzeichnet,**
**dass** ein Brennstoffeinspritzventil (4) mit einer Düsennadel (10) vorgesehen ist, dass das Brennstoffeinspritzventil (4) den piezoelektrischen Aktor (2) umfasst und dass der piezoelektrische Aktor (2) zum Betätigen der Düsennadel (10) dient.

3. Anordnung nach Anspruch 2,
**dadurch gekennzeichnet,**
**dass** der piezoelektrische Aktor (2) zum direkten Betätigen der Düsennadel (10) dient.

4. Anordnung nach Anspruch 2 oder 3,
**dadurch gekennzeichnet,**
**dass** zumindest ein Temperatursensor (30, 31) vorgesehen ist, der zum Erfassen der zumindest einen Betriebstemperatur dient.

5. Anordnung nach Anspruch 4,
**dadurch gekennzeichnet,**
**dass** der zumindest eine Temperatursensor (30, 31) zumindest mittelbar zumindest eine Betriebstemperatur zumindest eines Gehäuseteils (6) des Brennstoffeinspritzventils (4) und/oder eine Betriebstemperatur des piezoelektrischen Aktors (2) erfasst.

6. Anordnung nach einem der Ansprüche 1 bis 5,
**dadurch gekennzeichnet,**
**dass** die Steuerung (3) ausgestaltet ist, die zumindest eine Betriebstemperatur auf Grundlage von einer gemessenen, momentanen Kapazität des piezoelektrischen Aktors (2) zu erfassen.

7. Anordnung nach einem der Ansprüche 2 bis 6,
**dadurch gekennzeichnet,**
**dass** die Steuerung (3) das Steuersignal in Abhängigkeit von der zumindest einen Betriebstemperatur so anpasst, dass in einer Ruhelage des piezoelektrischen Aktors (2) ein unabhängig von der zumindest einen Betriebstemperatur vorgegebenes Soll-Spiel des piezoelektrischen Aktors (2) im Brennstoffeinspritzventil (4) zumindest näherungsweise beibehalten ist.

8. Anordnung nach einem der Ansprüche 1 bis 7,
**dadurch gekennzeichnet,**
**dass** die Steuerung (3) in Abhängigkeit von der zumindest einen erfassten Betriebstemperatur eine Steuerspannung (U) des Steuersignals durch Addition einer positiven, negativen oder verschwindenden Korrekturspannung (U_{K}) zu der Steuerspannung (U) anpasst und dass die Steuerung (3) den piezoelektrischen Aktor (2) mit einer Gesamtspannung (U + U_{K}) ansteuert, die sich aus der Summe der Steuerspannung (U) und der Korrekturspannung (U_{K}) zusammen setzt.

9. Anordnung nach Anspruch 8,
**dadurch gekennzeichnet,**
**dass** die Korrekturspannung (U_{K}) in Abhängigkeit von der zumindest einen Betriebstemperatur aus einem Bereich von etwa -40 V bis etwa 250 V erzeugt wird.

10. Verfahren zur Ansteuerung eines piezoelektrischen Aktors (2) mit einem Steuersignal, wobei das Steuersignal in Abhängigkeit von zumindest einer erfassten Betriebstemperatur angepasst wird.

11. Verfahren nach Anspruch 10,
**dadurch gekennzeichnet,**
**dass** in Abhängigkeit von der zumindest einen erfassten Betriebstemperatur eine Korrekturspannung (U_{K}) bestimmt wird, dass die bestimmte Korrekturspannung (U_{K}) zu der Steuerspannung (U) addiert wird und dass der piezoelektrische Aktor (2) mit einer Gesamtspannung (U + U_{K}) angesteuert wird, die sich aus der Steuerspannung (U) und der Korrekturspannung (U_{K}) ergibt.
